Europäisches Patentamt

European Patent Office

Office européen des brevets

(19)

(11) Numéro de publication: **0 271 397**
**A1**

(12) **DEMANDE DE BREVET EUROPEEN**

(21) Numéro de dépôt: **87402644.6**

(22) Date de dépôt: **24.11.87**

(51) Int. Cl.4: **G 01 R 5/02**
G 01 R 7/08, G 01 R 1/30,
G 01 D 11/24

(30) Priorité: **26.11.86 FR 8616473**

(43) Date de publication de la demande:
**15.06.88 Bulletin 88/24**

(84) Etats contractants désignés: **DE ES GB IT**

(71) Demandeur: **JAEGER**
**2, rue Baudin**
**F-92303 Levallois-Perret (FR)**

(72) Inventeur: **Chapotot, Michel**
**26, rue Eugénie**
**F-95150 Taverny (FR)**

(74) Mandataire: **Martin, Jean-Jacques et al**
**Cabinet REGIMBEAU 26, Avenue Kléber**
**F-75116 Paris (FR)**

(54) **Dispositif d'affichage à bobinage, et équipage pivotant, du type galvanomètre ou logomètre.**

(57) La présente invention concerne un dispositif d'affichage à bobinage et équipage pivotant, du type galvanomètre ou logomètre. Selon l'invention le dispositif d'affichage comprend, solidaire de son boîtier (10), un support (12) en matériau électriquement isolant, qui porte d'une part au moins une pastille de circuit intégré (14) servant de circuit de commande pour le dispositif, et d'autre part une série de bandes (20) en matériau électriquement conducteur, adaptées pour relier la pastille de circuit intégré (14) et au moins un bobinage du dispositif (10) et pour recevoir des signaux électriques de commande générés par des circuits externes.

FIG_1

**Description**

## DISPOSITIF D'AFFICHAGE A BOBINAGE, ET EQUIPAGE PIVOTANT, DU TYPE GALVANOMETRE OU LOGOMETRE.

La présente invention concerne le domaine des dispositifs d'affichage à bobinage et équipage pivotant , du type galvanomètre ou logomètre.

On rappelle que les galvanomètres comprennent un équipage pivotant muni d'un bobinage porté à pivotement dans l'entrefer d'un aimant. Un ressort de rappel sollicite l'équipage vers une position de repos. Lorque un courant de commande est appliqué au bobinage, le couple moteur électromagnétique résultant déplace l'équipage pivotant. La position d'équilibre est obtenue lorsque le couple de rappel défini par le ressort égale le couple moteur électromagnétique.

Les logomètres comprennent un équipage pivotant muni d'un aimant porté à pivotement entre deux bobinages croisés recevant des courants électriques de commande. L'aimant de l'équipage mobile s'aligne sur le champ magnétique généré par les bobinages.

La présente invention a pour but de proposer un nouveau dispositif d'affichage du type galvanomètre ou logomètre qui soit compact, fiable et économique.

La demanderesse a notamment constaté que, d'une façon générale, la fabrication en série de dispositifs d'affichage du type galvanomètre ou logomètre ne permet pas toujours d'aboutir à des dispositifs ayant tous la même loi de transformation. Il existe dans la pratique une dispersion notable de fabrications et les dispositifs d'affichage d'une même série ne sont pas interchangeables les uns avec les autres. Ceci constitue bien entendu un inconvénient extrêmement gênant.

Un autre but important de la présente invention est donc de proposer un dispositif d'affichage du type galvanomètre ou logomètre qui permette d'éliminer les dispersions inévitables de loi de transformation : signal électrique de commande/angle de pivotement de l'équipage mobile.

Ces différents buts sont atteints, dans le cadre de la présente invention, grâce à un dispositif d'affichage à bobinage et équipage pivotant , du type galvanomètre ou logomètre, qui comprend solidaire de son boîtier un support en matériau électriquement isolant, qui porte d'une part au moins une pastille de circuit intégré servant de circuit de commande pour le dispositif, et d'autre part une série de bandes en matériau électriquement conducteur adaptées pour relier la pastille de circuit intégré et au moins un bobinage du dispositif et pour recevoir des signaux électriques de commande générés par des circuits externes.

Selon une caractéristique avantageuse de l'invention, les contacts électriques établis entre les bandes en matériau électriquement conducteur et les circuits externes générant les signaux électriques de commande, sont établis au niveau de cambrures réalisées au niveau d'extrémité des bandes en matériau électriquement conducteur, sur le chant du support.

Dans le cas de dispositif d'affichage du type galvanomètre comprenant un ressort de rappel électriquement conducteur, de préférence le ressort de rappel est relié à l'une des bandes en matériau électriquement conducteur portée par le support pour assurer l'alimentation dun bobinage de l'équipage mobile.

Selon une autre caractéristique avantageuse de l'invention la pastille de circuit intégré comprend un élément définissant un paramètre lié à la loi de transformation du dispositif : grandeur électrique de commande en entrée/angle de pivotement de l'équipage mobile.

D'autres caractéristiques, buts et avantages de la présente invention apparaîtront à la lecture de la description détaillée qui va suivre et en regard des dessins annexés donnés à titre d'exemple non limitatif et sur lesquels :

- la figure 1 représente une vue schématique générale en perspective d'un dispositif d'affichage du type galvanomètre conforme à la présente invention,

- la figure 2 représente une vue schématique générale en perspective d'un dispositif d'affichage du type logomètre conforme à la présente invention,

- les figures 3A et 3B illustrent deux modes de réalisation conformes à la présente invention des cambrures ménagées en extrémité des bandes en matériau électriquement conducteur portées par le support,

- la figure 4 illustre de façon schématique le processus de fabrication des dispositifs d'affichage conformes à la présente invention.

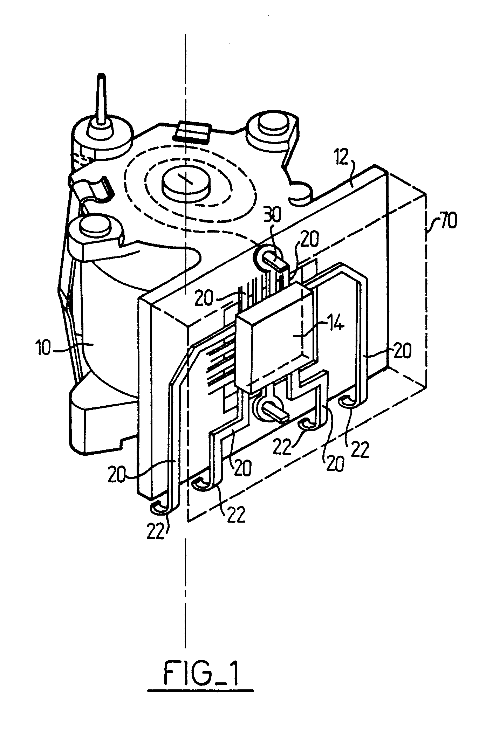

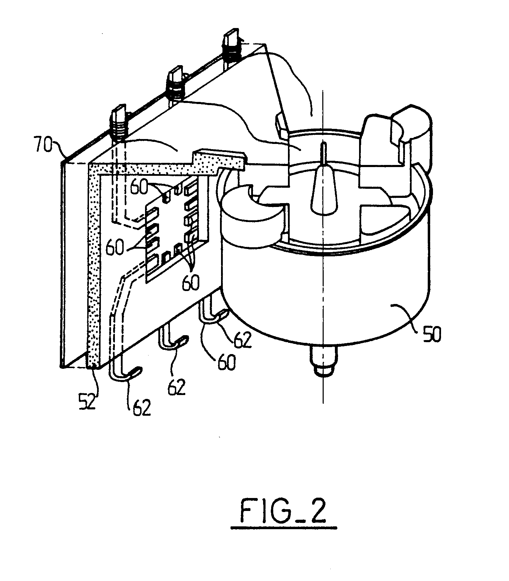

On aperçoit sur les figures 1 et 2, respectivement, les boîtiers 10, 50 d'un galvanomètre et d'un logomètre.

La structure de ces galvanomètre et logomètre, classique en soi, ne sera pas décrite plus en détail par la suite.

Selon la présente invention un support en matériau électriquement isolant, généralement plan, référencé respectivement 12 et 52 sur les figures 1 et 2, est solidaire des boîtiers 10, 50. Le support plan et électriquement isolant 12, 52 porte d'une part, au moins une pastille de circuit intégré 14 servant de circuit de commande pour le dispositif et d'autre part, une série de bandes 20, 60 en matériau électriquement conducteur. Les bandes 20, 60 sont destinées à relier la pastille de circuit intégré 14 et au moins un bobinage du dispositif d'affichage. Les bandes 20, 60 sont également destinées à recevoir des signaux électriques de commande générés par des circuits externes.

Comme cela est illustré sur les figures 1 et 2, les contacts électriques établis entre les bandes 20, 60 en matériau électriquement conducteur et les circuits externes générant les signaux électriques de commande sont établis au niveau de cambrures 22, 62 réalisées aux extrémités des bandes en matériau électriquement conducteur 20, 60 sur le chant du support 12, 52.

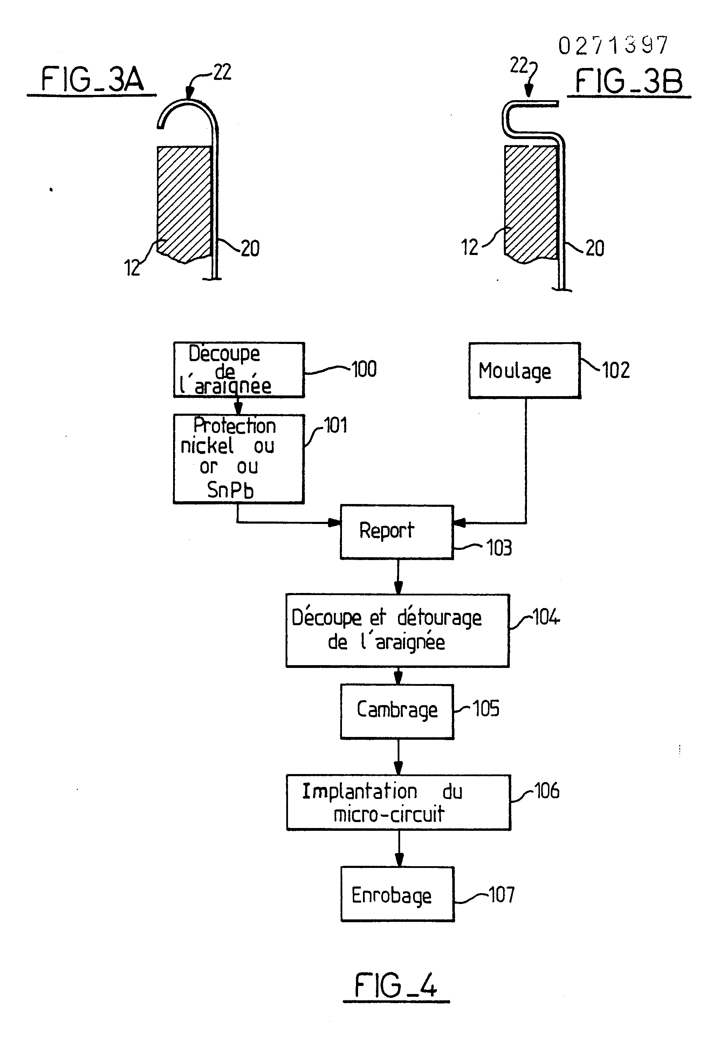

Les cambrures 22, 62 réalisées en extrémité des bandes 20, 60 peuvent faire l'objet de différents modes de réalisation. On a illustré sur les figures 3A et 3B annexées deux modes de réalisation de ces cambrures. Ces modes de réalisation sont bien entendu donnés à titre d'illustration et ne doivent pas être considérés comme limitatifs.

Selon l'illustration donnée sur les figures 3A et 3B chaque cambrure 22, 62 est formée d'une courbure en arc hémi-circulaire convexe vers l'extérieur du support 12, 52.

Dans le cas d'un dispositif d'affichage du type galvanomètre comme illustré sur la figure 1, de préférence le ressort de rappel 30 est électriquement conducteur et est relié à l'une des bandes 20 portées par le support 12 pour assurer l'alimentation du bobinage de l'équipage mobile.

De façon avantageuse, selon l'invention, la pastille de circuit intégré 14 comprend un élément, par exemple une mémoire définissant un paramètre lié à la loi de transformation du dispositif : grandeur électrique de commande en entrée/angle de pivotement de l'équipage mobile. Ledit paramètre défini par la pastille de circuit intégré, est personnalisé pour chaque dispositif d'affichage, lors de la fabrication, de telle sorte que si deux dispositifs d'affichage ayant des lois de transformation grandeur électrique de commande en entrée/angle de pivotement de l'équipage mobile, différentes en raison de la dispersion de fabrication, reçoivent le même signal électrique de commande en entrée, les dispositifs d'affichage fournissent un même angle de pivotement de l'équipage mobile. En d'autres termes, le circuit de commande tient compte dudit paramètre pour déterminer le signal appliqué au bobinage du dispositif d'affichage.

Le support électriquement isolant 12, 52 est de préférence réalisé en matière plastique chargée tenant les températures classiques de soudure à la vague, par exemple en polyamide.

On va maintenant décrire succinctement le processus de fabrication du dispositif d'affichage conforme à la présente invention en regard de la figure 4.

Comme cela est illustré sur cette figure par l'étape référencée 100, la première phase du procédé consiste à réaliser un réseau de bandes en matériau électriquement conducteur, généralement dénommé "araignée", adaptées pour relier entre eux les circuits externes générant les signaux électriques de commande, la pastille de circuit intégré 14 portée par le support 12, 52 et au moins un bobinage de l'afficheur.

De tels réseaux de bandes électriquement conductrices 20, 60, peuvent être préparés selon les techniques classiques de réalisation de rubans pour mise en oeuvre du processus de "transfert automatique sur bandes" dénommé couramment TAB.

Plus précisément encore, le réseau de bandes électriquement conductrices 20, 60 peut être réalisé selon un processus consistant à :

- réaliser des fenêtres rectangulaires dans un film plastique en matériau électriquement isolant, par exemple un film en mylar,
- à coller une feuille de cuivre sur le film plastique,
- à déposer une résine photo sensible sur la couche de cuivre,
- à réaliser une insolation de celle-ci à travers un masque de géométrie approprié,
- à réaliser une gravure de la couche de cuivre selon toute technique de gravure connue en soi.

Comme illustré par l'étape référencée 101 sur la figure 4, le réseau de bandes électriquement conductrices 20, 60 ainsi réalisé est ensuite protégé par dépôt d'une couche de protection à base de nickel ou d'or et de SnPb ou autres.

En parallèle des étapes 100 et 101 précitées, il est nécessaire d'opérer le moulage du support 12, 52 solidaire du boîtier 10, 50, comme illustré par l'étape référencée 102 sur la figure 4.

Comme indiqué précédemment, le support électriquement isolant 10, 50 est de préférence réalisé en matière plastique chargée tenant à des températures classiques de soudure à la vague, par exemple en polyamide.

Comme illustré à l'étape 103 sur la figure 4, le réseau 20, 60 de bandes électriquement conductrices (dénommé couramment "araignée") est ensuite collé à plat sur le support électriquement isolant 12, 52.

L'assemblage des bandes 20, 60 sur le support 12, 52 peut être fait selon diverses techniques, telles que surmoulage, soudure aux ultrasons, bouterollage ou collage simple.

Comme illustré à l'étape 104 sur la figure 4, on procède ensuite à la découpe et au détourage de l'araignée afin de libérer les extrémités internes des bandes conductrices 20, 60 destinées à recevoir la pastille de circuit intégré 14 et les extrémités externes des bandes destinées à être reliées au bobinage du dispositif d'affichage et au circuit externe.

L'étape ultérieure de fabrication consiste à assurer le cambrage des extrémités 22, 62 des bandes électriquement conductrices 20, 60 comme illustré à l'étape 105 sur la figure 4.

Le support 12, 52 est alors disponible pour recevoir la pastille de circuit intégré 14 comme illustré à l'étape 106 sur la figure 4.

Diverses techniques d'implantation de la pastille de circuit intégré 14 et de liaison de celles-ci avec les bandes 20, 60 peuvent être retenues.

Selon une première technique d'implantation et de raccordement, la pastille de circuit intégré 14 est collée sur le support 12, 52 puis les bornes de la pastille 14 sont reliées aux extrémités des bandes électriquement conductrices 20, 60 par l'intermédiaire de fils électriquement conducteurs selon la technique classique de "bonding".

Plus précisément, la pastille de circuit intégré 14 peut être reliée aux bandes 20, 60 à l'aide de fils d'or selon la technique de "ball bonding" ou à l'aide de fils d'aluminium selon la technique de "wedge bonding".

Ces techniques de soudure utilisent généralement des ultrasons, l'une à une température comprise entre 150 et 180°, l'autre à température ambiante.

Selon une autre technique de raccordement, les bornes de la pastille de circuit intégré 14 peuvent être revêtues d'une couche d'étamage à base d'étain et/ou de plomb, de même que les extrémités des bandes 20, 60. La liaison des bornes de la pastille de circuit intégré 14 et des bandes 20, 60 est alors réalisée en assurant une soudure par refusion des zones d'étamage.

Comme illustré par l'étape référencée 107 sur la figure 4, de préférence, la pastille de circuit intégré 14 et le réseau de bandes électriquement conductrices 20, 60 associées est ultérieurement enrobé dans un surmoulage de résine, référencé 70. Un tel surmoulage peut être réalise en polyuréthanne. Il assure la protection de la pastille de circuit intégré 14 et des bandes 20, 60 associées.

Bien entendu la présente invention n'est pas limitée au mode de réalisation particulier qui vient d'être décrit mais s'étend à toutes variantes conformes à son esprit.

On a évoqué dans la description qui précède la possibilité de réaliser le support isolant 12, 52 à base de polyamide. De façon avantageuse, selon l'invention, ce support isolant peut également être réalisé en polyester chargé verre, par exemple en polybutylènetéréphtalate ou PETP ou en polyéthylènetéréphtalate.

**Revendications**

1. Dispositif d'affichage à bobinage et équipage pivotant, du type galvanomètre ou logomètre, caractérisé par le fait qu'il comprend, solidaire de son boîtier (10, 50), un support (12, 52) en matériau électriquement isolant, qui porte d'une part, au moins une pastille de circuit intégré (14) servant de circuit de commande pour le dispositif, et d'autre part, une série de bandes (20, 60) en matériau électriquement conducteur, adaptées pour relier la pastille (14) de circuit intégré et au moins un bobinage du dispositif et pour recevoir des signaux électriques de commande générés par des circuits externes.

2. Dispositif d'affichage selon la revendication 1, caractérisé par le fait que les contacts électriques établis entre les bandes (20, 60) en matériau électriquement conducteur et les circuits externes générant les signaux électriques de commande, sont établis au niveau de cambrures (22,62) réalisées au niveau d'extrémités des bandes (20, 60) en matériau électriquement conducteur, sur le chant du support (12, 52).

3. Dispositif d'affichage du type galvanomètre selon l'une des revendications 1 ou 2, comprenant un ressort de rappel (30) électriquement conducteur, caractérisé par le fait que le ressort de rappel (30) est relié à l'une des bandes (20) en matériau électriquement conducteur, porté par le support (12, 52), pour assurer l'alimentation d'un bobinage de l'équipage mobile.

4. Dispositif selon l'une des revendications 1 à 3, caractérisé par le fait que la pastille (14) de circuit intégré comprend un élément définissant un paramètre lié à la loi de transformation du dispositif : grandeur électrique de commande en entrée / angle de pivotement de l'équipage mobile.

5. Dispositif d'affichage selon l'une des revendications 1 à 4, caractérisé par le fait que le support en matériau électriquement isolant (12, 52) est réalisé en polyamide.

6. Dispositif d'affichage selon l'une des revendications 1 à 5, caractérisé par le fait qu'il est réalisé selon les étapes consistant :

i) à réaliser un réseau (20, 60) de bandes en matériau électriquement conducteur,

ii) à assurer l'assemblage du réseau de bandes (20, 60) et d'un support (12, 52) relativement rigide en matériau électriquement isolant, par surmoulage, collage, soudure aux ultrasons ou bouterollage,

iii) à assurer le cambrage de certaines au moins des bandes (20, 60) au niveau d'extrémités de celles-ci,

iv) à implanter la pastille de circuit intégré (14) sur le support (12, 52).

7. Dispositif d'affichage selon la revendication 6, caractérisé par le fait que la pastille de circuit intégré (14) est reliée aux bandes (20, 60) en matériau électriquement conducteur selon la technique connue en soi dite de "bonding".

8. Dispositif d'affichage selon la revendication 6, caractérisé par le fait que la pastille de circuit intégré (14) est reliée aux bandes (20, 60)en matériau électriquement conducteur, selon la technique connue en soi de report à plat et soudure par refusion.

FIG_1

## FIG_2

# FIG_3A

22

12  20

0271397

# FIG_3B

22

12  20

| | |
|---|---|
| Découpe de l'araignée 100 | Moulage 102 |

Protection nickel ou or ou SnPb 101

Report 103

Découpe et détourage de l'araignée 104

Cambrage 105

Implantation du micro-circuit 106

Enrobage 107

# FIG_4

Office européen
des brevets

**RAPPORT DE RECHERCHE EUROPEENNE**

Numero de la demande

EP 87 40 2644

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | US-A-4 370 613 (J.I. MONTAGU) * Colonne 4, lignes 45-64; figures 15-20 * | 1,2 | G 01 R 5/02 G 01 R 7/08 G 01 R 1/30 G 01 D 11/24 |
| A | DE-A-2 908 160 (NEUBERGER MESSINSTRUMENTE KG) * Revendications 1,2; page 18, ligne 27 - page 19, ligne 21; figure 2 * | 1 | |
| A | FR-A-2 412 737 (K. HEHL) * Page 5, lignes 14-21; figures 3,4 * | 1 | |
| A | FR-A-2 087 590 (SOCIETE FRANCAISE D'EQUIPMENTS POUR LA NAVIGATION AERIENNE) * Figure 1 * | 3 | |
| A | US-A-3 829 648 (R.F. HUDDLESTON) * Colonne 3, lignes 45-62; figure 2 * | 6 | |
| A | EP-A-0 192 349 (TEKTRONIX INC.) * Page 3, ligne 32 - page 4, ligne 5; figure 4 * | 6 | DOMAINES TECHNIQUES RECHERCHES (Int. Cl.4) G 01 R G 01 D G 12 B H 05 K |

Le présent rapport a été établi pour toutes les revendications

| Lieu de la recherche | Date d'achèvement de la recherche | Examinateur |
|---|---|---|
| LA HAYE | 26-02-1988 | PENZKOFER,B. |